Europäisches Patentamt

**European Patent Office**

**Office européen des brevets**

(11) Numéro de publication : **0 003 933**
**B1**

(19)

(12) **FASCICULE DE BREVET EUROPÉEN**

(45) Date de publication du fascicule du brevet :
09.09.81

(21) Numéro de dépôt : **79400098.4**

(22) Date de dépôt : **16.02.79**

(51) Int. Cl.³ : **G 01 R 1/06,** G 01 R 31/28,
H 01 L 21/66, H 05 K 13/00

(54) **Appareil pour établir des prises de contact temporaires sur des circuits électriques et son utilisation.**

(30) Priorité : **24.02.78 FR 7805302**

(43) Date de publication de la demande :
**05.09.79 (Bulletin 79/18)**

(45) Mention de la délivrance du brevet :
**09.09.81 Bulletin 81/36**

(84) Etats contractants désignés :
**CH DE IT NL**

(56) Documents cités :
**FR - A - 2 356 341**
**US - A - 3 399 363**

(73) Titulaire : **SOCIETE ANONYME DE TELECOMMUNI-CATIONS**
**40 avenue de New York**
**F-75116 Paris (FR)**

(72) Inventeur : **Guerpont, Maurice Roger**
**119 boulevard Gabriel Péri**
**F-92240 Malakoff(Hauts de Seine) (FR)**

(74) Mandataire : **Bloch, Robert**
**39 avenue de Friedland**
**F-75008 Paris (FR)**

Imprimerie Jouve, 17, rue du Louvre, 75001 Paris, France

Appareil pour établir des prises de contact temporaires sur des circuits électriques
et son utilisation

La présente invention concerne un appareil pour établir des prises de contact temporaires sur des circuits électriques, tels que des circuits à couche épaisse ou des circuits imprimés, que l'on désire contrôler ou dont on désire ajuster les composants.

Il est connu, pour établir des prises de contact sur un tel circuit, d'utiliser un support en forme générale de couronne sur lequel sont fixées autant de pointes de touche qu'il y a de prises de contact à établir, les pointes de touche devant être réglées séparément pour coïncider avec les accès des différentes lignes du circuit.

L'ensemble des pointes de touche sont appliquées simultanément sur le circuit et on sélectionne pour chaque ligne à contrôler la paire de contacts correspondante au moyen d'un jeu de relais.

Un tel dispositif, décrit par exemple dans la demande de brevet français 2 356 341, n'est applicable qu'à des circuits simples comprenant un nombre de lignes relativement restreint. En effet, lorsque ce nombre est important, le nombre de pointes de touche doit être élevé et le réglage individuel de chaque pointe de touche devient très difficile.

En outre, lorsque la mesure est utilisée pour ajuster les résistances du circuit, il faut absolument éviter que le jet de sable ou le rayon laser, dirigés perpendiculairement à la surface du circuit imprimé pour réaliser l'ajustage, rencontrent les pointes de touche. Cette condition est difficile à remplir si le nombre de pointes de touche doit être élevé.

Un autre inconvénient du dispositif connu est lié à la présence de relais dans le circuit de mesure, les résistances des relais devant être prises en considération dans les résultats de mesure.

Le brevet américain 3 399 363 décrit également un appareil de ce type, dans lequel les pointes de touche sont portées par des bras-supports pouvant être déplacés entre une position haute et une position basse dans laquelle les pointes de touche sont en contact avec le circuit électrique. Cet agencement vise à permettre de placer un grand nombre de pointes de touche sur le circuit, de façon à réaliser un grand nombre de mesures, mais il est clair que ce nombre est de toutes façons très limité. Cet appareil connu présente en outre les inconvénients déjà mentionnés ci-dessus.

L'invention vise un appareil pour établir des prises de contact temporaires sur un circuit à couche épaisse ou un circuit imprimé qui ne présente pas les inconvénients indiqués ci-dessus.

L'invention a pour objet un appareil pour établir des prises de contact temporaires sur un circuit électrique, comprenant au moins deux pointes de touche, des bras-supports portant respectivement les pointes de touche et des moyens pour déplacer les bras-supports entre une position haute et une position basse dans laquelle les pointes de touche sont en contact avec le circuit électrique. Cet appareil comprend des unités de déplacement respectives commandées par programme pour déplacer les bras-supports de façon que les pointes de touche puissent occuper toute position désirée dans un plan parallèle à celui du circuit à mesurer.

Dans l'appareil selon l'invention, les prises de contact successives sont obtenues par les déplacements programmés des deux pointes de touche, ce qui règle tous les problèmes signalés plus haut.

De façon appropriée, chaque unité de déplacement comprend une table inférieure, une première unité d'entraînement pour déplacer la table inférieure dans une première direction, un plateau intermédiaire placé au-dessus de la table inférieure et monté mobile par rapport à celle-ci dans une seconde direction orthogonale à la première, le bras-support respectif étant solidaire du plateau intermédiaire, une table supérieure placée au-dessus du plateau intermédiaire, une seconde unité d'entraînement pour déplacer la table supérieure dans la seconde direction, le plateau intermédiaire étant mobile par rapport à la table supérieure dans la première direction, et des moyens pour fixer la position relative des deux unités d'entraînement dans chacune desdites directions.

Dans une telle unité de déplacement, la partie mobile à entraîner est à tout moment limitée au plateau intermédiaire et à une seule des tables et possède donc une très faible inertie. Cela est très important car cela permet des vitesses de déplacements élevées sur les déplacements très courts qu'effectuent les pointes de touche, donc des gains de temps appréciables. Avec le système classique dans lequel la table inférieure, munie d'une unité d'entraînement, porte la table supérieure et l'unité d'entraînement associée, et l'organe à déplacer est fixé sur la table supérieure, tel que décrit par exemple dans le brevet américain 3 399 363, la partie mobile peut comprendre l'organe à déplacer, les deux tables et l'unité d'entraînement de la table supérieure, ce qui correspond à une inertie très importante. Les vitesses de déplacement seraient alors très nettement inférieures et le temps nécessaire pour l'opération serait beaucoup plus long.

L'invention sera bien comprise à la lecture de la description suivante, faite en se référant au dessin annexé, dans lequel :

La figure 1 est une vue de dessus schématique de l'appareil de prise de contact selon l'invention,

La figure 2 est une vue de face, partiellement en coupe, qui illustre le montage des bras-supports,

La figure 3a est une vue de face d'une des unités de déplacement,

La figure 3b est une vue de côté de l'unité de déplacement représentée à la fig. 3a,

La figure 4 est une vue de dessus de l'unité de déplacement des figs. 3a et 3b,

La figure 5 est une vue de face à plus grande échelle du mécanisme de transmission pour l'entraînement d'une des tables de l'unité de déplacement,

La figure 6a montre en vue de dessus la moitié inférieure du mécanisme de transmission de la fig. 5, et

La figure 6b montre en vue de dessus la moitié supérieure du mécanisme de transmission de la fig. 5.

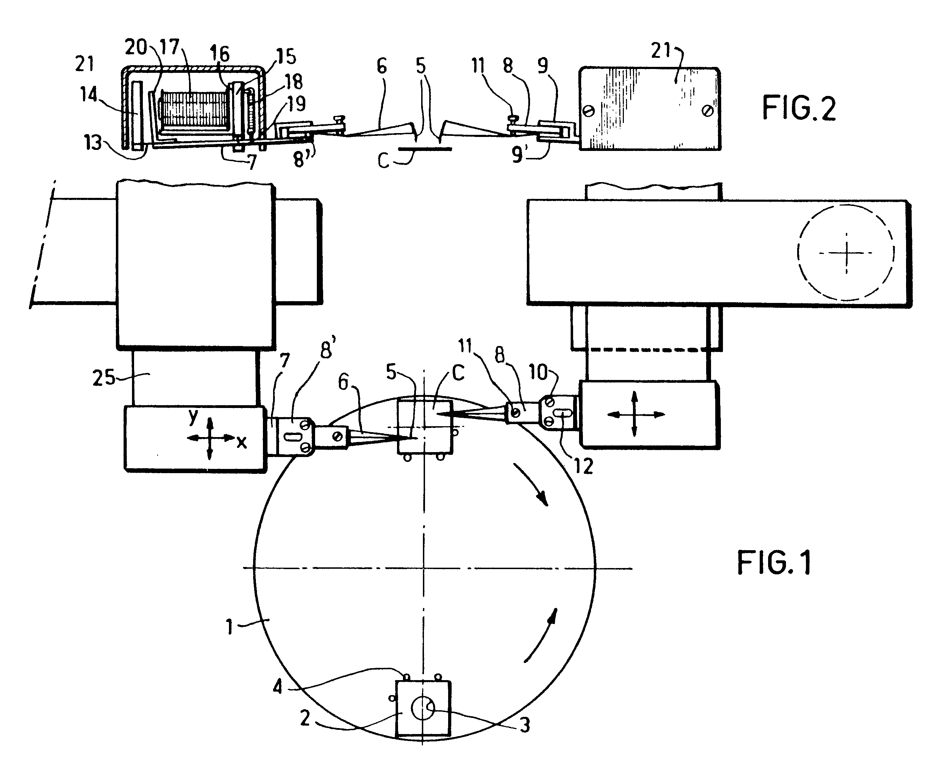

On a représenté à la fig. 1 un plateau tournant 1 destiné à recevoir les circuits dont on veut contrôler les différents composants. Le plateau tournant comporte deux emplacements 2 dont l'un est occupé par une plaquette de circuit C en cours de contrôle, l'autre étant réservé à la mise en place d'une autre plaquette. Le trou 3 qu'on voit à l'emplacement inoccupé sert au maintien de la plaquette par dépression. Des petites butées 4 servent de références pour positionner les plaquettes.

L'appareil de prise de contact comprend deux pointes de touche 5 destinées à être placées aux bornes du composant du circuit dont on veut mesurer une caractéristique, en particulier d'une résistance en couche épaisse. Chacune des pointes de touche 5 (voir fig. 2) constitue l'extrémité d'un corps 6 en métal conducteur qui est fixé en porte-à-faux à l'extrémité d'un bras-support 7.

Le mode de fixation du corps 6 sur le bras-support 7 peut être quelconque pourvu qu'il permette un réglage en hauteur limité de l'extrémité de la pointe de touche 5. Dans l'exemple décrit, le corps 6 se termine par une languette mince, donc légèrement flexible, prise entre deux cales en matière isolante 8,8'. Les cales 8,8' sont maintenues entre les branches 9,9' du bras-support 7 en forme de fourchette, les branches 9,9' étant légèrement rapprochées l'une de l'autre par des vis 10 de façon à bloquer en position les cales.

De plus, la cale supérieure 8 comporte un prolongement qui porte une vis 11 pour le réglage en hauteur de la pointe de touche 5. On notera également que la branche supérieure 9 est munie d'une ouverture 12 pour le passage d'une connexion électrique (non représentée) reliant directement le corps 6 à un appareil de mesure électrique.

Comme on peut le voir à la fig. 2, chaque bras-support est fixé par son extrémité opposée aux branches 9,9' à une lame 13 légèrement flexible, laquelle est bloquée par des moyens non représentés, par exemple une vis, à un élément de châssis 14. Un autre élément de châssis 15 parallèle à l'élément 14 porte une équerre 16 sur laquelle est fixée une bobine d'électro-aimant 17. De plus, un ressort de traction 18 est fixé entre l'élément de châssis 15 et le bras-support 7 et rappelle ce dernier en contact avec une surface de butée 19 définie par une ouverture ménagée dans l'élément 15. Un élément en forme de L 20, de préférence en fer doux, est fixé à la lame 13 du côté opposé au bras-support 7 et comporte une partie susceptible d'être attirée par l'électro-aimant 17 lorsque celui-ci est excité. Lorsque cela se produit, le mouvement de l'élément 20 en direction de l'électro-aimant entraîne un abaissement du bras-support 7 par pivotement de la lame 13. La pointe de touche 5 portée par le bras-support entre ainsi en contact avec le circuit C. Lorsqu'on coupe ensuite l'alimentation de l'électro-aimant, la force d'attraction cesse et le ressort 18 ramène le bras-support 7 dans la position haute représentée sur la fig. 2. La pointe de touche s'écarte alors du circuit.

La position basse correspond bien entendu aux phases de mesure pendant lesquelles les pointes de touche sont immobiles, et la position haute correspond aux phases de déplacement des pointes de touche d'un point du circuit à un autre.

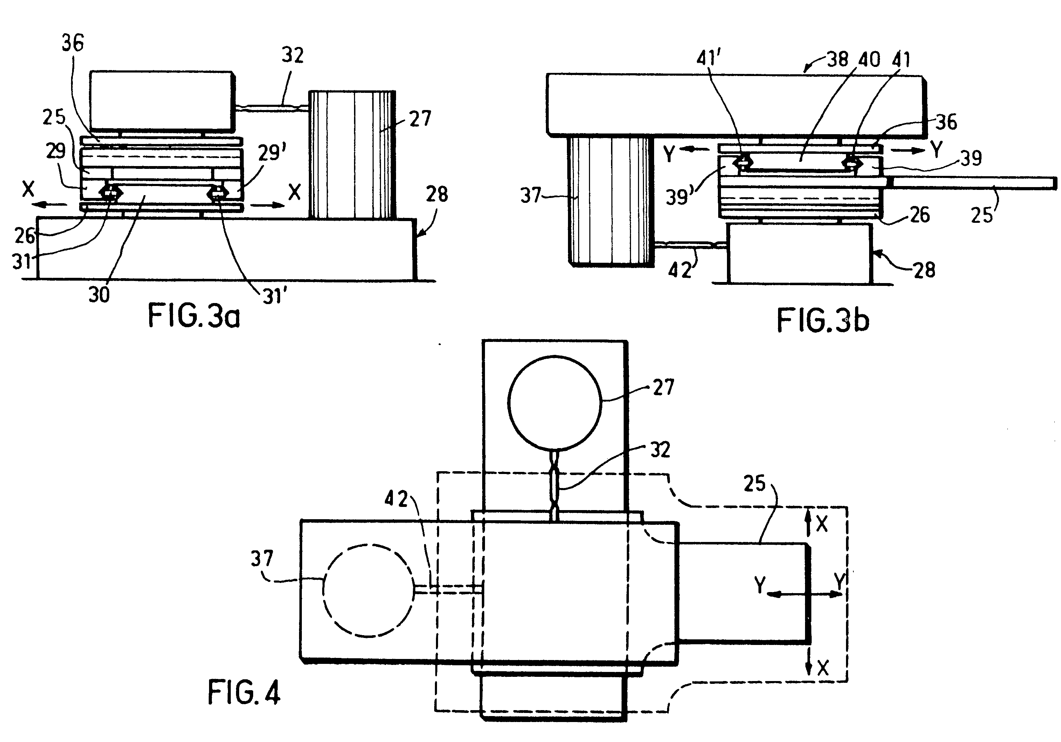

Les flèches X, Y sur la fig. 1 indiquent les deux axes orthogonaux de déplacement des bras-supports 7 portant les pointes de touche. Pour l'entraînement des bras-supports, les deux éléments de châssis 14, 15 sont fixés, par exemple par des vis non représentées, sur un plateau 25 entraîné suivant les deux axes X, Y par des moyens qu'on décrira ci-après en détail en référence aux figs. 3-6. En outre, un boîtier de protection 21 fixé aux éléments de châssis 14, 15 entoure l'électro-aimant 17.

On se réfère à présent aux figs. 3a, 3b et 4 qui montrent une forme de réalisation préférée des moyens permettant de déplacer le plateau 25 suivant les axes X, Y.

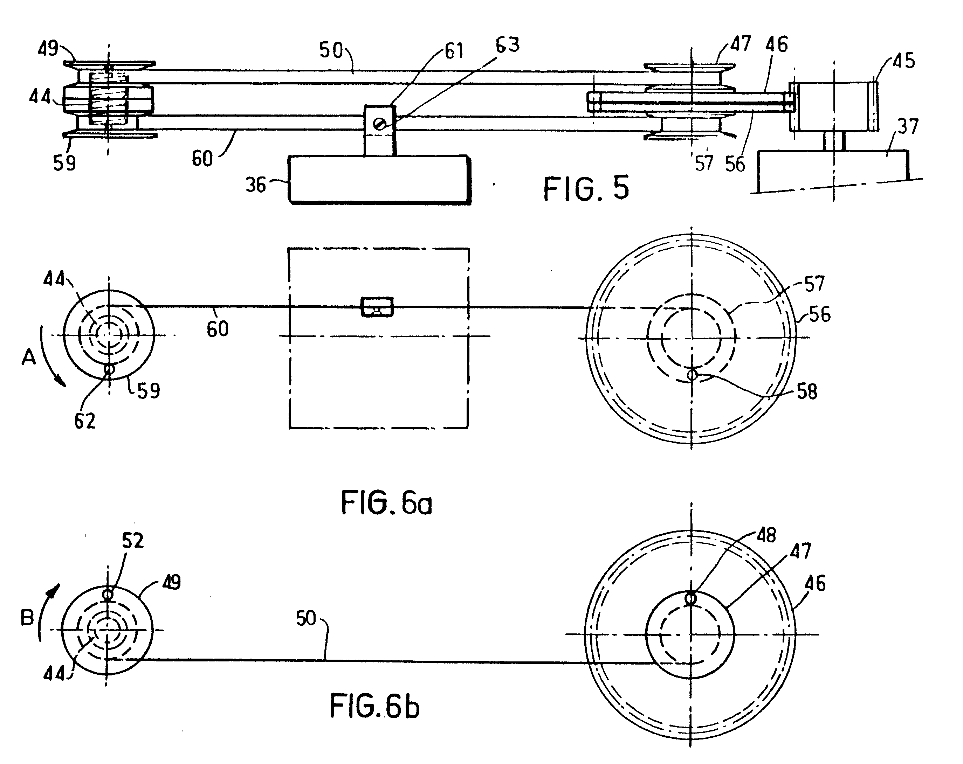

Le plateau 25, qu'on appellera dans la suite le plateau intermédiaire, est pris en sandwich entre deux tables, une table inférieure 26 et une table supérieure 36. La table inférieure 26 est entraînée dans la direction X (cf. fig. 3a) par une unité d'entraînement comprenant un moteur pas à pas 27 et un mécanisme de transmission désigné dans son ensemble par la référence 28 et décrit plus en détail ci-après en référence aux figs. 5 et 6a-6b. D'autre part, le plateau intermédiaire 25 est monté mobile par rapport à la table inférieure 26 dans la direction orthogonale à la direction X, c'est-à-dire dans la direction Y. A cet effet, on peut utiliser tous moyens appropriés. Dans l'exemple décrit, le plateau intermédiaire se prolonge vers le bas par des éléments de guidage 29,29' situés sur ses bords parallèles à la direction Y, la table inférieure 26 comporte un élément de guidage central 30, et des rouleaux croisés 31,31' de type connu sont montés entre les surfaces, en regard des éléments de guidage, conformées de façon correspondante, c'est-à-dire munies d'un profil en V. Les rouleaux croisés permettent un déplacement sans aucun frottement du plateau intermédiaire 25 par rapport à la table inférieure 26.

On notera cependant que des roulements à billes pourraient aussi bien être utilisés à la place des rouleaux croisés.

La partie supérieure de l'unité de déplacement est identique à la partie inférieure qu'on vient de décrire, et est disposée perpendiculairement à celle-ci. La table supérieure 36 est entraînée dans la direction Y (cf. fig. 3b) par un moteur pas à pas 37 par l'intermédiaire d'un mécanisme de transmission 38. Le plateau intermédiaire 25 comporte des éléments de guidage latéraux 39,39' sur ses bords parallèles à la direction X, lesquels coopèrent avec un élément de guidage central 40 de la table supérieure par l'intermédiaire de rouleaux croisés 41,41'.

En outre, une tige de réaction 32 est montée entre le moteur pas à pas 27 et le boîtier du mécanisme de transmission 38 pour fixer la position relative des deux ensembles d'entraînement dans la direction X, et une tige de réaction 42 est montée entre le moteur 37 et le boîtier du mécanisme de transmission 28 pour fixer la position relative des deux ensembles d'entraînement dans la direction Y.

Lorsqu'un déplacement selon la direction X doit se produire, le moteur 27 est mis en marche, il entraîne la table inférieure 26 qui entraîne elle-même le plateau intermédiaire 25 dans la direction X. Pendant ce temps, la table supérieure 36 reste fixe et le déplacement imposé au plateau intermédiaire 25 le fait coulisser par rapport à elle. Lorsque c'est un déplacement suivant Y qui doit se produire, c'est le moteur 37 qui est mis en marche et la table supérieure 36 qui entraîne le plateau intermédiaire 25, lequel coulisse ainsi par rapport à la table inférieure 26 qui reste fixe.

L'avantage essentiel de l'unité de déplacement décrite est lié à sa structure symétrique, et réside dans le fait que les parties en mouvement sont limitées à tout moment au plateau intermédiaire 25 (plus les pièces très légères qu'il porte) et à une seule des tables, soit la table inférieure 26, soit la table supérieure 36. L'inertie résultante est donc très réduite, ce qui permet d'arriver à des vitesses de déplacement relativement très élevées, pouvant aller jusqu'à 50 mm/s. Une inertie très faible est un facteur essentiel dans ce type d'appareils, car les déplacements sont extrêmement courts, de l'ordre de 1 à 5 mm — la plaquette de circuit C ayant des dimensions d'environ 25 × 25 mm. Si l'inertie était importante, la phase de freinage au cours d'un déplacement donné devrait déjà intervenir bien avant la fin de la phase d'accélération, si bien que la vitesse normale ne pourrait jamais être atteinte. La durée totale de l'opération s'en trouverait allongée dans des proportions importantes.

Un autre avantage réside dans la standardisation du matériel puisque les ensembles d'entraînement supérieur et inférieur sont composés d'éléments identiques, donc interchangeables.

On se réfère ensuite aux figs. 5 et 6a, 6b qui représentent en détail le mécanisme de transmission désigné par les références 28, 38 aux figs. 3a, 3b. On supposera qu'il s'agit ici du mécanisme 38. Ce mécanisme relie le moteur pas à pas 37 à la table supérieure 36. Il comprend un pignon 45 monté sur l'arbre de sortie du moteur 37 qui engrène avec deux roues dentées 46, 56 montées rotatives sur un arbre non représenté, symbolisé par le trait mixte. Une poulie 47 est solidaire de la roue supérieure 46 (cf. fig. 6b). De même, une poulie 57 est solidaire de la roue inférieure 56 (cf. fig. 6a).

La poulie supérieure 47 est reliée à une poulie 49 par un ruban métallique 50 — fixé sur celles-ci au moyen des clavettes 48 et 52 — de manière à entraîner en rotation la poulie 49 lorsque les roues 46, 56 tournent dans le sens inverse des aiguilles d'une montre, vu sur la fig. 6b. La poulie inférieure 57 est de même reliée à une poulie 59 par un ruban métallique 60 — fixé sur ces poulies par des clavettes 58 et 62 — de manière à entraîner celle-ci en rotation lorsque les roues 46, 56 tournent dans le sens des aiguilles d'une montre. Un élément 61 fixé à la table 36 est muni d'une fente dans laquelle on place le ruban 60, et une vis 63 serre le ruban de façon à assurer un entraînement sans glissement de l'élément 61 par le ruban 60. Dans la position des figs. 6a, 6b, les points d'attache des rubans 50, 60 sont à mi-course. La course de rotation totale des poulies est de ± 135° par rapport à cette position. Ainsi, un ruban ne peut jamais s'enrouler sur lui-même.

D'autre part, les poulies 49 et 59 sont montées coaxiales et un ressort de torsion 44 est monté à l'intérieur des poulies 49, 59 de manière que son extrémité supérieure soit fixée à la poulie supérieure 49 et son extrémité inférieure à la poulie inférieure 59. Le ressort 44 exerce par conséquent une force de rappel sur la poulie supérieure 49 qui tend à faire tourner celle-ci dans le sens de la flèche B de la fig. 6b, et exerce sur la poulie inférieure 59 une force qui tend à la faire tourner dans le sens indiqué par la flèche A à la fig. 6a. Dans les deux cas, la force exercée par le ressort 44 s'oppose à la force de traction exercée sur les poulies 49, 59 par les rubans respectifs 50, 60. Le ressort 44 assure donc en permanence un rattrapage du jeu qui survient inévitablement entre les engrenages 45 et 46, 56. On obtient ainsi une grande précision dans la transmission du mouvement du moteur 27 à la table 26. L'élimination des jeux assurée par le ressort 44 est très importante compte tenu du fait que le mouvement effectué par une pointe de touche est constitué d'une succession de déplacements très courts.

La commande des moteurs pas à pas 27, 37 est réalisée à partir d'un programme établi en fonction du circuit à contrôler. Ce programme peut être enregistré sur un support tel qu'une bande perforée, ou simplement enregistré dans la mémoire d'un microordinateur.

Le programme commande également l'excitation de l'électro-aimant 17 de façon que celui-ci reste désexcité pendant le déplacement de la pointe de touche respective et soit excité à la fin du déplacement. La pointe de touche entre alors en contact avec le circuit et la mesure peut s'effectuer. Une fois la mesure faite, l'électro-aimant est désexcité, la pointe de touche se relève et un nouveau déplacement peut commencer.

L'appareil selon l'invention peut être combiné de manière très avantageuse avec une tête d'usinage par faisceau laser ou une tête de sablage, en vue de réaliser l'ajustage des résistances du circuit aux valeurs prévues. Dans ce cas, on harmonise les déplacements de la tête d'usinage et des pointes de touche, c'est-à-dire que la tête d'usinage est dirigée sur la résistance aux bornes desquelles sont placées les pointes de touche, et le fonctionnement de la tête d'usinage est réglé sur le résultat de la mesure. L'usinage s'arrête lorsque la valeur mesurée devient égale, aux tolérances près, à la valeur théorique prévue.

Dans une telle application, il faut absolument éviter que l'une des pointes de touche se trouve sur le passage du rayon laser ou du jet de sable. Or cela ne présente pas de difficultés avec l'appareil selon l'invention qui ne compte que deux pointes de touche.

Il faut encore souligner que l'appareil permet de réaliser l'ajustage des résistances et le contrôle final après adjonction des éléments discrets. Cela ne serait absolument pas possible avec le dispositif classique en forme de couronne.

## Revendications

1. Appareil pour établir des prises de contact temporaires sur un circuit électrique, comprenant au moins deux pointes de touche (5), des bras-supports (7) portant respectivement les pointes de touche (5) et des unités de déplacement respectives commandées par programme pour déplacer les bras-supports de façon que les pointes de touche puissent occuper toute position désirée dans un plan parallèle à celui du circuit à mesurer, caractérisé par le fait que les bras-supports (7) sont déplaçables entre une position haute et une position basse dans laquelle les pointes de touche sont en contact avec le circuit électrique (C), et chaque unité de déplacement comprend une table inférieure (26), une première unité d'entraînement pour déplacer la table inférieure dans une première direction, un plateau intermédiaire (25) placé au-dessus de la table inférieure et monté mobile par rapport à celle-ci dans une seconde direction orthogonale à la première, le bras-support respectif étant solidaire du plateau intermédiaire, une table supérieure (36) placée au-dessus du plateau intermédiaire, une seconde unité d'entraînement pour déplacer la table supérieure dans la seconde direction, le plateau intermédiaire étant mobile par rapport à la table supérieure dans la première direction, et des moyens pour fixer la position relative des deux unités d'entraînement dans chacune des dites directions.

2. Appareil selon la revendication 1, caractérisé par le fait que chaque unité d'entraînement comprend un moteur pas à pas (27, 37), un mécanisme de transmission (28, 38) comprenant deux poulies (47, 57) menantes coaxiales et entraînées par le moteur dans le même sens, deux poulies (49, 59) menées coaxiales, deux rubans (50, 60) non extensibles reliant respectivement les poulies menantes aux poulies menées, les deux rubans étant montés de manière à se déplacer en sens inverses, un ressort de torsion (44) relié par ses extrémités respectives aux poulies menées, le ressort agissant pour s'opposer à la force de traction exercée par les rubans sur les poulies menées respectives, et un élément d'accouplement (61, 63) pour rendre la table associée solidaire de l'un des rubans.

3. Appareil selon la revendication 2, caractérisé par le fait qu'une tige de réaction (32, 42) dirigée suivant chacune des dites directions est montée entre le moteur de l'unité d'entraînement dans la dite direction et le mécanisme de transmission de l'unité d'entraînement dans l'autre direction.

4. Appareil selon la revendication 1, caractérisé par le fait que chaque bras-support (7) est monté pivotant sur le plateau intermédiaire (25) respectif et est déplaçable dans la position basse par un électro-aimant (17) porté par le plateau intermédiaire contre l'action d'un ressort (18).

5. Utilisation de l'appareil selon l'une des revendications 1 à 4 pour l'ajustage des résistances d'un circuit électrique.

## Claims

1. Apparatus for establishing temporary contacts on an electric circuit, comprising at least two contact points (5), support arms (7) respectively bearing the contact points (5), and respective displacement units controlled by program to displace the support arms so that the contact points can occupy any desired position in a plane parallel to that of the circuit to be measured, characterised in that the support arms (7) can be moved between a high position and a low position in which the contact points are in contact with the electric circuit (c), and each displacement unit comprises a lower table (26), a first drive unit for displacing the lower table in a first direction, an intermediate plate (25) placed above the lower table and mounted to move with respect thereto in a second direction at right angles to the first, the respective support arm being fast with the intermediate plate, an upper table (36) placed above the intermediate plate, a second drive unit to displace the upper table in the second direction, the intermediate plate being mobile with respect to the upper table in the first direction, and means for fixing the relative position of the two drive units in each of said directions.

2. Apparatus according to Claim 1, characterised in that each drive unit comprises a step by step motor (27, 37), a transmission mechanism (28, 38) comprising two coaxial driving pulleys (47, 57) driven by the motor in the same direction, two coaxial driven pulleys (49, 59), two non-extensible belts (50, 60), connecting the driving pulleys to the driven pulleys, respectively, the two belts being mounted so as to move in opposite directions, a torsion spring (44) connected by its respective ends to the driven pulleys, the spring acting to oppose the force of traction exerted by the belts on the respective driven pulleys, and a coupling member (61, .63) for fasting the associated table with one of the belts.

3. Apparatus according to Claim 2, characterised in that a reaction rod (32, 42) directed in each of said directions, is mounted between the motor of the drive unit in said direction and the transmission mechanism of the drive unit in the other direction.

4. Apparatus according to Claim 1, characterised in that each support arm 7 is rotatably mounted on the respective intermediate plate (25) and is movable in the low position by an electromagnet (17) carried by the intermediate plate against the action of a spring (18).

5. Use of the apparatus according to one of Claims 1 to 4, for adjusting the resistors of an electric circuit.


**Ansprüche**

1. Vorrichtung für die zeitweilige Kontaktabnahme bei einem elektrischen Stromkreis, mit mindestens zwei Kontaktspitzen (5), gesonderten Tragarmen (7) für die beiden Kontaktspitzen (5) und programmgesteuerten Verstelleinheiten für eine derartige Verschiebung der Tragarme, daß die Kontaktspitzen jede gewünschte Position in einer parallel zur Ebene des zu messenden Stromkreises liegenden Ebene einzunehmen vermögen. dadurch gekennzeichnet, daß die Tragarme (7) zwischen einer oberen Stellung und einer unteren Stellung beweglich sind, in der die Kontaktspitzen mit dem elektrischen Stromkreis (C) in Kontakt sind, und daß jede Verstelleinheit eine Unterplatte (26), ein erstes Antriebsaggregat für die Verlagerung der Unterplatte in einer ersten Verschieberichtung, eine oberhalb der Unterplatte angeordnete Zwischenplatte (25), an der der zugeordnete Tragarm befestigt ist und die relativ zur Unterplatte in einer zur ersten Verschieberichtung rechtwinkligen zweiten Verschieberichtung beweglich ist, eine oberhalb der Zwischenplatte befindliche Oberplatte (36), ein zweites Antriebsaggregat für die Verlagerung der Oberplatte in der zweiten Verschieberichtung, wobei die Zwischenplatte relativ zur Oberplatte in der ersten Verschieberichtung beweglich ist, und Elemente aufweist, um die Relativposition der beiden Antriebsaggregate in jeder der beiden Verschieberichtungen zu fixieren.

2. Vorrichtung nach Anspruch 1, dadurch gekennzeichnet, daß jedes Antriebsaggregat einen Schrittmotor (27, 37), einen Übertragungsmechanismus (28, 38), der zwei von dem Schrittmotor gleichsinnig antreibbare koaxiale Antriebsscheiben (47, 57), zwei koaxiale Abtriebsscheiben (49, 59), zwei nicht dehnbare Bänder (50, 60), die jeweils die Antriebsscheiben mit den zugeordneten Abtriebsscheiben koppeln und so angebracht sind, daß sie sich in entgegengesetzten Richtungen bewegen, eine Torsionsfeder (44), deren Enden mit der einen Abtriebsscheibe einerseits bzw. mit der anderen Abtriebsscheibe andererseits verbunden sind, derart, daß diese Torsionsfeder entgegen der von den Bändern auf die jeweiligen Abtriebsscheiben ausgeübten Zugkraft wirksam ist, und ein Kupplungselement (61, 63) enthält, um die zugeordnete Platte mit jeweils einem der Bänder zu koppeln.

3. Vorrichtung nach Anspruch 2, dadurch gekennzeichnet, daß ein Reaktionsschaft (32, 42), der entsprechend jeder der beiden Verschieberichtungen ausgerichtet ist, zwischen dem dieser Verschieberichtung zugeordneten Schrittmotor und dem der anderen Verschieberichtung zugeordneten Übertragungsmechanismus angebracht ist.

4. Vorrichtung nach Anspruch 1, dadurch gekennzeichnet, daß jeder Tragarm (7) gegenüber der zugeordneten Zwischenplatte schwenkbar befestigt ist und gegen die Kraft einer Rückstellfeder (18) mittels eines von der Zwischenplatte getragenen Elektromagneten (17) nach unten beweglich ist.

5. Verwendung einer Vorrichtung gemäß einem der Ansprüche 1 bis 4 zur Widerstandsmessung eines elektrischen Stromkreises.

FIG.2

FIG.1

FIG.3b

FIG.3a

FIG.4

0 003 933

FIG. 5

FIG. 6a

FIG. 6b